# EUROPEAN PATENT SPECIFICATION

(11) **EP 1 843 201 B1**
(45) Date of publication and mention of the grant of the patent: **18.01.2012**
(21) Application number: 07005629.6
(22) Date of filing: 19.03.2007
(51) Int. Cl.: G03F 1/62

(54) **Pellicle for lithography**
Schutzmembrane für Lithographie
Pellicule pour lithographie

(30) Priority: 07.04.2006 JP 2006106432; 12.07.2006 JP 2006192019
(43) Date of publication of application: 10.10.2007
(73) Proprietor: Shin-Etsu Chemical Co., Ltd., Tokyo (JP)
(72) Inventor: Shirasaki, Toru, Annaka-shi Gunma-ken (JP)
(74) Representative: Müller, Thomas

(56) References cited:
- EP-A- 1 473 598
- EP-A1- 0 893 736
- WO-A-03/092256
- WO-A-2007/009543
- DE-A1- 10 351 607
- JP-A- 6 347 999
- GORDON J S: "Pellicles designed for high performance lithographic processes" PROCEEDINGS OF THE SPIE - THE INTERNATIONAL SOCIETY FOR OPTICAL ENGINEERING SPIE-INT. SOC. OPT. ENG USA, vol. 2512, 1995, pages 99-111, XP002444535 ISSN: 0277-786X
- SAKURAI I ET AL: "PELLICLE FOR ARF EXCIMER LASER PHOTOLITHOGRAPY" PROCEEDINGS OF THE SPIE, SPIE, BELLINGHAM, VA, US, vol. 3748, 13 April 1999 (1999-04-13), pages 177-187, XP001028068 ISSN: 0277-786X
- WOOD J ET AL: "DUV pellicle quality assessment based on customer priorities" PROCEEDINGS OF THE SPIE - THE INTERNATIONAL SOCIETY FOR OPTICAL ENGINEERING SPIE-INT. SOC. OPT. ENG USA, vol. 3546, 1998, pages 422-428, XP002444543 ISSN: 0277-786X

## Description

### BACKGROUND OF THE INVENTION

### 1. Field of the Invention

The present invention relates to a pellicle for lithography, in particular to a pellicle for lithography used as dust-proof protection in the manufacture of semiconductor devices such as LSIs and ultra-LSIs, or liquid crystal display panels or the like. More particularly, the invention relates to a pellicle for lithography used for ultraviolet exposure of 200 nm or shorter wavelength, which is employed in exposure where high resolution is required.

### 2. Description of the Background Art

Conventionally, the manufacture of semiconductor devices such as LSIs and ultra LSIs devices, or liquid crystal display panels and the like, involves patterning of semiconductor wafers or liquid crystal base plates through irradiation of light. However, this is problematic in that any dust particles adhering to the photomask plates used in such cases absorb and reflect light, which deforms and roughens the edge lines of the transferred patterning, thereby impairing the dimensions, quality, appearance and performance of the semiconductor device and/or liquid crystal display panel, while reducing the manufacturing yield thereof.

Thus, these procedures are usually carried out in a clean room, but keeping the photomask always in good conditions within such a clean room is difficult, and hence a pellicle is mounted on the surface of the photomask, for dust-proof protection, the pellicles having herein good transmissivity to the exposure light.

Doing so is advantageous in that dust particles are not deposited directly onto the surface of the photomask, but become deposited onto the pellicle membrane, so that during photolithography the dust particles on the pellicle membrane never affect transfer, since the focus is in accord with the pattern of the photomask.

Herein, a transparent pellicle membrane formed from nitrocellulose, cellulose acetate or the like, and having high transmissivity to the exposure light is coated, dissolved in a good solvent towards the pellicle membrane, onto the upper portion of a pellicle framework formed from aluminium, stainless steel, polyethylene or the like, then the pellicle is dried to become bonded to the pellicle framework (Japanese Patent Application Laid-open No. S58-219023); alternatively, the pellicle membrane can be bonded using an adhesive agent such as an acrylic resin (US Patent No. 4861402), an epoxy resin (Japanese Patent Examined Application Publication No. S63-27707), an amorphous fluoropolymer (Japanese Patent Application Laid-open No. H07-168345) or the like, while to the underside of the pellicle framework is attached to an adhesive layer comprising a polybutene resin, a polyvinyl acetate resin, an acrylic resin, a silicone resin or the like, and a release layer (separator) for protection of the adhesive layer.

Publication Pellicles Designed for High Performance Lithographic Process "(by Gordon, SPiE, vol. 2512, pages 99 to 111) describes off-axis transmission for pellicles. According to this publication, the transmissivity is dependent on the incident angle and on the pellicle thickness for G-line and I-line wavelenght.

In the wake of ever higher photolithography resolutions encountered in recent years, the light sources employed are resorting to gradually shorter wavelengths in order to realize such resolutions.

Specifically, there has been a shift towards ultraviolet light (g-line (436 nm), i-line (365 nm), KrF excimer lasers (248 nm)), while recently ArF excimer lasers (193 nm) are at the debut for use.

The use of shorter wavelengths in photolithography implies using light of a higher energy, for which reason transparent fluorocarbon resins, having a higher resistance to laser beams, have come to be used as pellicle membranes for KrF and ArF lasers (Japanese Patent Examined Application Publication No. S63-27707 and Japanese Patent Application Laid-open No. H07-168345).

The use of immersion exposure devices employing an ArF excimer laser for still finer processing has begun to be studied in recent years (International Patent Application No. WO99/49504). A higher NA (numerical aperture) can be realized by filling with a liquid the gap space between the objective lens of the exposure device and the silicon wafer, which as a result allows to accomplish higher resolution.

When the gap between the objective lens and the silicon wafer is filled with pure water, the theoretical limit of the NA becomes about 1.44, but constraints in the lenses and others make for an actual NA limit in practice of about 1.3.

Exposure devices having thus a higher NA afford a larger inclined incidence angle in portions surrounding the light passing through the pellicle. Herein, the maximum inclinedly incident angle is of about 15 degrees for a NA of 1, increasing to about 19 degrees for a NA of 1.3, with slight variations depending on the exposure device.

The transmissivity of the pellicle is designed usually so as to become a maximum transmissivity to vertically incident beams, and the pellicle is manufactured accordingly; transmissivity decreases, however, as the inclined incidence angle (angle formed between vertically incident beams and inclinedly incident beams) increases. The thickness of the ArF pellicles usually employed is of about 830 nm. However, transmissivities are herein extremely low, of about 96% to 15 degree inclined incident beams, and of about 92% to 19 degree inclined incident beams, even for a pellicle having a transmissivity of about 100% to vertically incident beams.

EP 0893 736 A1 describes a method for sticking a pellicle to an item to protected. The pellicle thickness ranges from 100nm to 10.000 nm. The pellicle thickness can be selected such than the transmittance for exposure wavelength in a range of 140 nm to 200 nm is high for vertically incident beams.

A lower pellicle transmissivity, and/or a gradually decreasing transmissivity on account of the incidence angle, give rise to irradiation unevenness during exposure, which detracts from photolithographic quality. A lower transmissivity translates also into larger reflection on the pellicle surface, which gives rise to problems such as flare or the like, thereby impairing photolithographic quality. Among other problems that may arise, the light reflected by the surface of the pellicle membrane becomes scattered light that can lead to material degradation by impinging on non-required locations inside the exposure device.

Japanese Patent Examined Application Publication No. S63-27707 studies the "average beam transmittance" of a "dust-proof cover for a photomask", the wavelength of the studied light beams ranging herein from "240 to 500 nm". This patent document is silent on the light transmittance of inclinedly incident beams.

### SUMMARY OF THE INVENTION

In light of the above, the object of the present invention is to provide a pellicle for lithography used in the photolithography, the pellicle for lithography affording a broader range of transmissivity to inclinedly incident beams that can be used in the photolithographic procedure.

The pellicle for lithography of the present invention is a pellicle used in the photolithography using ArF excimer laser beams and characterized in that the pellicle has a pellicle membrane having a thickness at which the membrane exhibits a local maximum transmissivity to inclinedly incident Art excimer laser beams of 13.4 degrees, said membrane possessing a transmissivity exceeding 98% to incidence angles ranging from 0 to 19 degrees, said thickness not exceeding 600 nm.

Further features and details of the present invention become evident from the dependent claims, from the description and from the accompanied drawings.

Preferably, the pellicle membrane has a thickness in a range selected from 560 to 563 nm and/or 489 to 494 nm and/or 418 to 425 nm and/or 346 to 355 nm and/or 275 to 286 nm and/or 204 to 217 nm.

The present invention allows providing a pellicle membrane in a pellicle for use in photolithography using ArF excimer laser beams, the pellicle membrane possessing a high transmissivity, exceeding 98%, to inclined incidence up to 19 degrees, by adjusting the thickness of the pellicle membrane not to exceed 600 nm.

According to the present invention adjustment of the thickness so as to exhibit a local maximum transmissivity to inclinedly incident ArF laser beams of 13.4 degrees allows minimizing the incidence angle dependency of the pellicle transmissivity for an incidence angle range of 0 to 19 degrees of inclinedly incident ArF laser beams. In this case, the thickness of the pellicle membrane may be by about 1.4% thicker than the thickness that exhibits a local maximum transmissivity to vertically incident ArF laser beams.

When the thickness of the pellicle membrane is a thickness exhibiting a local maximum transmissivity to inclinedly incident ArF laser beams of 13.4 degrees, moreover, adjusting the thickness of the pellicle membrane not to exceed 600 nm allows providing a pellicle membrane possessing a high transmissivity, exceeding 98%, to an incidence angles ranging from 0 to 19 degrees.

To summarize the present invention, the invention provides a pellicle for lithography used in the photolithography, affording a wider range of transmissivity to inclinedly incident beams that can be used in a photolithographic procedure. The pellicle is characterized by having a pellicle membrane having a thickness at which the membrane exhibits a local maximum transmissivity to an inclinedly incident ArF excimer laser beam. Herein, the angle of inclined incidence is 13.4 degrees, and the pellicle membrane has a thickness of 600 nm or smaller, in particular in a range selected from 560 to 563 nm and 489 to 494 nm and 418 to 425 nm and 346 to 355 nm and 275 to 286 nm and 204 to 217 nm.

### BRIEF DESCRIPTION OF THE DRAWINGS

FIG. 1 is a graph illustrating the incidence angle dependency of transmissivity in the pellicle membrane of Example 1;
FIG. 2 is a graph illustrating the incidence angle dependency of transmissivity in the pellicle membrane of Example 2;
FIG. 3 is a graph illustrating the incidence angle dependency of transmissivity in the pellicle membrane of Example 3;
FIG. 4 is a graph illustrating the incidence angle dependency of transmissivity in the pellicle membrane of Example 4;
FIG. 5 is a graph illustrating the incidence angle dependency of transmissivity in the pellicle membrane of Example 5;
FIG. 6 is a graph illustrating the incidence angle dependency of transmissivity in the pellicle membrane of Example 6; and
FIG. 7 is a graph illustrating the incidence angle dependency of transmissivity in the pellicle membrane of Comparative Example 1.

### DESCRIPTION OF THE PREFERRED EMBODIMENTS

Pellicles are usually used for a short-wavelength light, and hence are designed and manufactured so as to have a maximum transmissivity to light of such wavelengths. Pellicle thickness is controlled by optical interference effects, as it is known that at certain thickness values transmissivity acquires maximum values. A thinner pellicle has a higher transmissivity since the membrane material gives rise to smaller scattering and the like; on the other hand, a thicker pellicle has higher mechanical strength and is easier to handle. Current pellicles used for ArF lasers strike a compromise herein by controlling mostly pellicle thickness to about 830 nm.

As is described above, however, pellicle thickness is set so as to achieve maximum transmissivity towards vertical incidence, and hence, although the pellicle exhibits a transmissivity of virtually 100% to vertically incident beams, transmissivity decreases as the incidence angle increases, as described above, with a transmissivity of only about 92% for 19 degree inclinedly incident beams, which is a problem when the pellicle is used in a high-NA exposure device.

Also, incidence angle dependency can be made smaller by setting the thickness of the pellicle membrane to a thickness exhibiting a local maximum transmissivity to inclinedly incident light, and not vertically incident ArF laser beams, instead of controlling the thickness of the pellicle membrane so as to exhibit a maximum transmissivity to the vertically incident light. The inventors also found that, although the transmissivity to vertically incident light decreases when the thickness of the pellicle membrane is set to a thickness exhibiting a local maximum transmissivity to inclinedly incident ArF laser beams of 13.4 degrees, transmissivity to inclinedly incident light up to 19 degrees increases, and incidence angle dependency of transmissivity to inclinedly incident light decreases within an incidence angle range of 0 to 19 degrees.

The inventors have found out further that, when the thickness of the pellicle membrane is a thickness exhibiting a local maximum transmissivity to inclinedly incident ArF laser beams of 13.4 degrees, adjusting the thickness of the pellicle membrane not exceeding 600 nm allows manufacturing a pellicle membrane possessing a high transmissivity, exceeding 98%, to incidence angles ranging from 0 to 19 degrees, thereby preventing the occurrence of the above-described problems.

Also, a pellicle membrane possessing a high transmissivity, exceeding 98%, to incidence angles ranging from 0 to 19 degrees can be manufactured to a greater thickness by setting the thickness of the pellicle membrane to a thickness exhibiting a local maximum transmissivity to inclinedly incident ArF laser beams of 13.4 degrees, than it can be setting the thickness of the pellicle membrane to a thickness exhibiting a local maximum transmissivity to vertically incident ArF laser beams. This allows providing, therefore, a pellicle having a higher mechanical strength and a transmissivity having smaller incidence angle dependency.

Specifically, a pellicle can be manufactured having a transmissivity of 98% or higher to incidence angles ranging from 0 to 19 degrees, by controlling the thickness of the pellicle membrane to be in a range selected from 560 to 563 nm and 489 to 494 nm and 418 to 425 nm and 346 to 355 nm and 275 to 286 nm and 204 to 217 nm.

### EXAMPLES

### Example 1

A 3% solution prepared by dissolving a perfluoroether polymer having a cyclic structure, Cytop CTX-S (product name by Asahi Glass Co.) in perfluorotributylamine was dripped onto a silicon wafer, and spread thereon by rotating the wafer at 850 rpm on a spin coater to give a uniform layer of the resin solution which was subjected to drying by first standing at room temperature for 30 minutes and then heating at 180°C. An aluminum frame coated on the lower end surface with an adhesive was put onto the resin film to be bonded to the resin film which was then lifted from the silicon wafer to serve as a pellicle membrane.

A surface-anodized aluminum frame having outer dimensions of 149 mm by 122 mm by 5.8 mm height was coated on the upper end surface with a membrane adhesive and on the lower end surface with a pressure-sensitive adhesive for photomask was adhesively bonded to the resin film taken up on the aluminum frame on the upper end surface to complete a frame-supported pellicle after trimming of the membrane by clipping the marginal portions of the resin film.

The pellicle membrane of the thus finished pellicle had a thickness of 277 nm as measured. This thickness was a thickness exhibiting a local maximum transmissivity to a vertically incident ArF excimer laser beam (wavelength 193 nm).

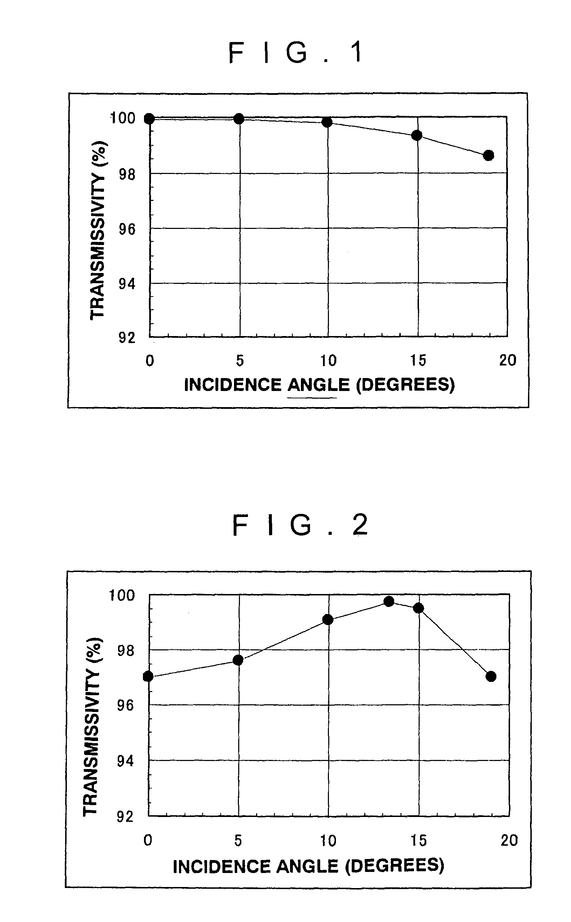

Upon measurement of the incidence angle dependency of the transmissivity, the pellicle exhibited a high transmissivity, of at least 98%, for all incidence angles from 0 to 19 degrees, although decreasing gradually as the incidence angle increased, from a transmissivity of 99.9% for vertical incidence (incidence angle 0 degrees) through 99.8% for 10 degree inclinedly incident beams and 98.6% for 19 degree inclinedly incident beams. FIG. 1 illustrates the angle dependency of transmissivity in this instance.

### Example 2

A 5% solution of a perfluoroether polymer having a cyclic structure, Cytop CTX-S (by Asahi Glass Co.) dissolved in perfluorotributylamine was dripped onto a silicon wafer, and was spread thereon by rotating the wafer at 835 rpm by spin coating. The solution was then converted into a uniform film by drying first for 30 minutes at room temperature, followed by heating at 180°C. Thereto was bonded an aluminum framework coated with an adhesive agent, then the resin film alone was lifted to serve as a pellicle membrane.

A membrane adhesive agent was applied to the top face of a frame made of aluminum and subjected to a surface anodization treatment having outer dimensions of 149 mm by 122 mm by 5.8 mm height, while on the underside was coated with a pressure-sensitive adhesive agent. Thereafter, the adhesive agent side was bonded to the pellicle membrane taken up on the aluminum framework, and the membrane on the portion extending from the periphery of the frame was clipped for trimming to complete a framed pellicle.

The finished pellicle had a thickness of 842 nm as measured. This thickness corresponded to a local maximum transmissivity to 13.4 degrees inclinedly incident beams of an ArF laser (wavelength 193 nm).

Upon measurement of the incidence angle dependency of the transmissivity of the pellicle, the latter exhibited a transmissivity having an extremely low incidence angle dependency, with a lowest transmissivity of 97%, namely 97% for vertical incidence (incidence angle 0 degree), and 99.1 % for 10 degrees, 99.7% for 13.4 degrees, and 97.0% for 19 degrees of inclinedly incident beams, as compared with a case (Comparative Example 1), in which the thickness was set to exhibit local maximum transmissivity to vertically incident light. FIG. 2 illustrates the angle dependency of transmissivity in this Example.

### Example 3

A 4% solution of a perfluoroether polymer having a cyclic structure, Cytop CTX-S, supra, in perfluorotributylamine was dripped onto a silicon wafer, and was spread thereon by rotating the wafer at 900 rpm on a spin coater. The solution was then converted into a uniform film first by standing for 30 minutes at room temperature and then heating at 180°C. An aluminum frame coated with an adhesive was bonded to the thus dried film on the silicon wafer and the film was lifted to give a pellicle membrane.

A surface-anodized aluminum frame having outer dimensions of 149 mm by 122 mm by 5.8 mm height was coated on the top face with an adhesive and bonded to the membrane supported on the aluminum frame followed by trimming of the membrane to finish a framed pellicle.

The membrane of the thus finished pellicle had a measured thickness of 421 nm. This thickness corresponded to a local maximum transmissivity to 13.4 degrees inclinedly incident beams of an ArF laser (wavelength 193 nm).

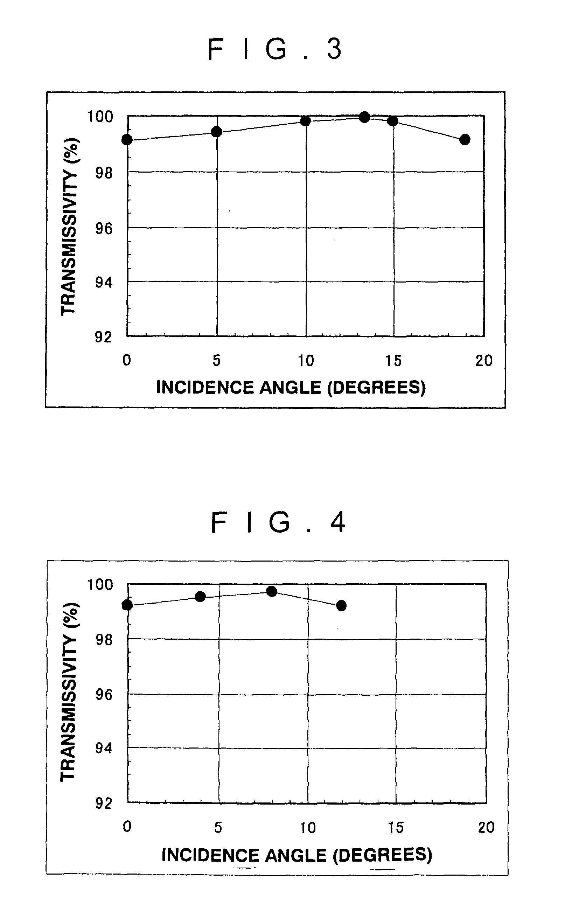

Upon measurement of the incidence angle dependency of the transmissivity, the pellicle exhibited a high transmissivity of at least 99%, for all incidence angles from 0 to 19 degrees, and a transmissivity having a small incidence angle dependency, of 99.1% for vertical incidence (incidence angle 0 degree), and 99.8% for 10 degrees, 99.9% for 13.4 degrees, and 99.1 % for 19 degrees of inclinedly incident beams. FIG. 3 illustrates the angle dependency of transmissivity in this Example.

### Example 4

A 5% solution of a perfluoroether polymer having an a cyclic structure, Cytop CTX-S, supra, dissolved in perfluorotributylamine was dripped onto a silicon wafer, and was spread thereon by rotating the wafer at 845 rpm on spin coater. The solution was then converted into a uniform film by standing g for 30 minutes at room temperature, followed by heating at 180°C. Thereto was bonded an aluminum frame coated with an adhesive agent. Then the membrane alone was lifted to give a pellicle.

A membrane adhesive agent was applied to the top face of a frame made of aluminum subjected to the surface anodization treatment (outer dimensions: 149 mm by 122 mm by 5.8 mm height), while on the underside was coated with a mask adhesive agent. Thereafter, the adhesive agent side was bonded to the pellicle membrane taken on the aluminum framework, and the membrane on the outer periphery of the frame was trimmed to complete thereby a pellicle.

The finished pellicle had a measured thickness of 835 nm. This thickness corresponded to a local maximum transmissivity to inclinedly incident beams of about 8 degrees of an ArF laser (wavelength 193 nm).

Upon measurement of the incidence angle dependency of the transmissivity of this pellicle, the pellicle exhibited a transmissivity of 99.2% for 0 degree inclinedly incident beams, 99.7% for 8 degree inclinedly incident beams, and 99.2% for 12 degree inclinedly incident beams.

A pellicle membrane manufactured so as to have local maximum transmissivity to inclinedly incident beams of about 8 degrees exhibited a higher lowest transmissivity, and a smaller incidence angle dependency, with a lowest transmissivity of 99.2% in the range of 0 to 12 degrees, than a case (Comparative Example 1) in which thickness is set so as to give a local maximum transmissivity to vertically incident light, and exhibiting a lowest transmissivity of 97.8% to inclinedly incident beams in the range of 0 to 12 degrees. FIG. 4 illustrates the angle dependency of transmissivity in this instance.

### Example 5

A 5% solution of a perfluoroether polymer having a cyclic structure, Cytop CTX-S, supra, dissolved in perfluorotributylamine was dripped onto a silicon wafer, and was spread thereon by rotating the wafer at 834 rpm on a spin coater. The solution was then converted into a uniform film through drying for 30 minutes at room temperature, followed by heating at 180°C. Thereto was bonded an aluminum framework coated with an adhesive agent, then the membrane alone was lifted to give a pellicle.

A membrane adhesive agent was applied on the top face of a surface-anodized aluminum frame having outer dimensions of 149 mm by 122 mm by 5.8 mm height, while on the underside was coated with a photomask adhesive agent. Thereafter, the adhesive agent-coated side was put onto the pellicle membrane supported on the aluminum framework, and the membrane was trimmed by clipping the marginal portions extending from the aluminum frame to finish a pellicle.

The finished pellicle had a measured thickness of 846 nm. This thickness exhibited a local maximum transmissivity to 15.2 degrees inclinedly incident beams of an ArF laser (wavelength 193 nm).

Upon measurement of the incidence angle dependency of the transmissivity of this pellicle, the latter exhibited a transmissivity of 98.4% for 10 degree inclinedly incident beams, 99.7% for 15 degrees inclinedly incident beams, and 98.4% for 19 degree inclinedly incident beams.

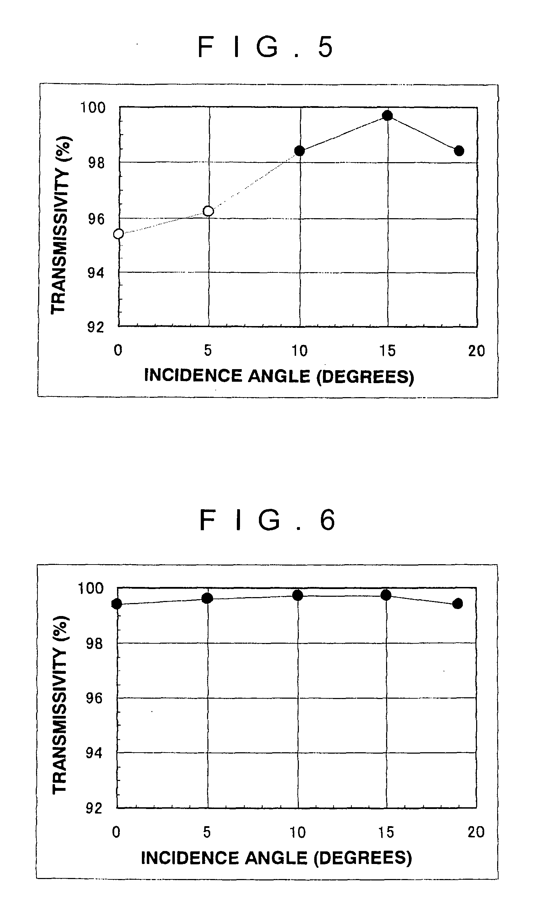

A pellicle membrane manufactured so as to have a local maximum transmissivity to inclinedly incident beams by about 15.2 degrees exhibited a higher lowest transmissivity, and an extremely low incidence angle dependency of the transmissivity, with a lowest transmissivity of 98.4% to inclinedly incident beams in the range of 10 to 12 degrees, than a case (Comparative Example 1) in which the thickness was set so as to give a local maximum transmissivity to vertically incident light, and exhibiting a lowest transmissivity of 92% to inclinedly incident beams in the range of 10 to 19 degrees. FIG. 5 illustrates the angle dependency of transmissivity in this Example.

### Example 6

A 3% solution of Cytop CTX-S, supra, dissolved in perfluorotributylamine was dripped onto a silicon wafer, and was spread thereon by rotating the wafer at 845 rpm on a spin coater. The solution was then converted into a uniform film by standing for 30 minutes at room temperature and then heating at 180°C. Thereto was bonded an aluminum framework coated with an adhesive agent, then the film alone was lifted to give a pellicle membrane.

A membrane adhesive agent was applied to the top face of a surface-anodized aluminum frame having outer dimensions of 149 mm by 122 mm by 5.8 mm height, while on the underside was coated with a photomask adhesive agent. Thereafter, the adhesive agent side was put onto the pellicle membrane supported on the aluminum framework, and the membrane was trimmed by clipping the marginal portions extending from the frame to finish a framed pellicle.

The thus finished pellicle had a measured thickness of 281 nm. This thickness corresponded to a local maximum transmissivity to 13.4 degrees inclinedly incident beams of an ArF laser (wavelength 193 nm).

Upon measurement of the incidence angle dependency of the pellicle, the latter exhibited a higher lowest transmissivity and a transmissivity having smaller incidence angle dependency, with 99.4% for to vertically incident beams (incidence angle 0 degree), 99.5% to 10 degrees inclinedly incident beams, and 99.4% to 19 degrees inclinedly incident beams, as compared with a case (Example 1) in which thickness is set so as to yield local maximum transmissivity to vertical incident beams, and having a lowest transmissivity of 99.4% in an incidence angle range of 0 to 19 degrees. FIG. 6 illustrates the angle dependency of the transmissivity in this case.

### Comparative Example 1

A 5% solution of a perfluoroether polymer having a cyclic structure, Cytop CTX-S, supra, dissolved in perfluorotributylamine was dripped onto a silicon wafer, and was spread thereon by rotating the wafer at 850 rpm on a spin coater. The solution was then converted into a uniform film by standing for 30 minutes at room temperature and then heating at 180°C. Thereto was bonded an aluminum framework coated with an adhesive agent, then the film alone was lifted to give a membrane for pellicle.

A membrane adhesive agent was applied to the top face of a surface-anodized aluminum frame having outer dimensions of 149 mm by 122 mm by 5.8 mm height, while on the underside was coated with a photomask adhesive agent. Thereafter, the adhesive agent -coated side was put to the pellicle membrane supported on the aluminum framework, and the membrane was trimmed by clipping the marginal portions extending from the aluminum frame thus to finish a frame-supported pellicle.

The thus finished pellicle had a measured thickness of 830 nm. This corresponded to a thickness exhibiting a local maximum transmissivity to a vertically incident ArF excimer laser beam (wavelength 193 nm).

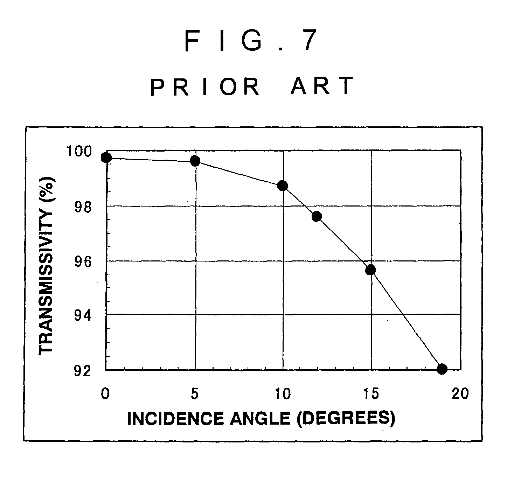

Upon measurement of the incidence angle dependency of the transmissivity, the pellicle exhibited a high transmissivity, of 99.7%, for vertical incidence (incidence angle 0 degree), but a transmissivity that decreased gradually as the incidence angle increased, of 98.7% for 10 degrees inclinedly incident beams, 92.0% for 19 degrees inclinedly incident beams, and of 98% or lower beyond 12 degrees. FIG. 7 illustrates the angle dependency of the transmissivity in this example.

The present invention enables to decrease the incidence angle dependency of pellicle transmissivity in the photolithographic process and hence enables to manufacture with improved productivity semiconductor devices, liquid crystal display panels and the like, and broadens the scope of application of immersion exposure, thereby significantly contributing to the field of information technology.

## Claims

1. A pellicle for lithography which is a pellicle used in the photolithography using ArF excimer laser beams and **characterized in that** the pellicle has a pellicle membrane having a thickness at which the membrane exhibits a local maximum transmissivity to inclinedly incident ArF excimer laser beams of 13.4 degrees, said membrane possessing a transmissivity exceedind 98% to incidence angles ranging from 0 to 19 degrees, said thikness not exceeding 600 nm.

2. The pellicle for lithography according to claim 1, **characterized in that** the pellicle membrane has a thickness in a range selected from 560 to 563 nm and/or 489 to 494 nm and/or 418 to 425 nm and/or 346 to 355 nm and/or 275 to 286 nm and/or 204 to 217 nm.

## Patentansprüche

1. Pellicle für die Lithographie, welches ein Pellicle ist, das in der Photolithographie unter Verwendung von ArF Excimer-Laserstrahlen verwendet wird und das **dadurch gekennzeichnet ist, dass** das Pellicle eine Pellicle-Membran aufweist, die eine Dicke aufweist, bei der die Membran ein lokales maximales Durchlassvermögen für schräg einfallende ArF Excimer Laserstrahlen von 13.4 Grad aufweist, wobei die Membran ein Durchlassvermögen von mehr als 98% für Einfallswinkel im Bereich von 0 bis 19 Grad aufweist, wobei die Dicke 600 nm nicht übersteigt.

2. Pellicle für die Lithographie gemäß Patentanspruch 1, **dadurch gekennzeichnet, dass** die Pellicle-Membran eine Dicke in einem Bereich aufweist, der ausgewählt ist von 560 bis 563 nm und/oder 489 bis 494 nm und/oder 418 bis 425 nm und/oder 346 bis 355 nm und/oder 275 bis 286 nm und/oder 204 bis 217 nm.

## Revendications

1. Pellicule pour lithographie qui est une pellicule utilisée dans la photolithographie utilisant des faisceaux laser à excimère ArF et **caractérisée en ce que** la pellicule comporte une membrane de pellicule ayant une épaisseur à laquelle la membrane présente une transmissivité maximale locale à des faisceaux laser à excimère Art incidents inclinés de 13,4 degrés, ladite membrane possédant une transmissivité dépassant 98 % aux angles d'incidence variant de 0 à 19 degrés, ladite épaisseur ne dépassant pas 600 nm.

2. Pellicule pour lithographie selon la revendication 1, **caractérisée en ce que** la membrane de pellicule a une épaisseur dans une plage choisie de 560 à 563 nm et/ou 489 à 494 nm et/ou 418 à 425 nm et/ou 346 à 355 et/ou 275 à 286 nm et/ou 204 à 217 nm.
